# EUROPEAN PATENT APPLICATION

(11) **EP 4 471 871 A1**
(43) Date of publication of application: **04.12.2024**
(21) Application number: 22938795.6
(22) Date of filing: 24.04.2022
(51) Int. Cl.: H01L 29/66, H01L 29/20, H01L 21/762

(54) **SEMICONDUCTOR DEVICE AND PREPARATION METHOD THEREFOR**

(71) Applicant: Huawei Technologies Co., Ltd., Shenzhen, Guangdong 518129 (CN)
(72) Inventor: TANG, Cen, Shenzhen, Guangdong 518129 (CN); RAO, Jin, Shenzhen, Guangdong 518129 (CN); LIU, Tao, Shenzhen, Guangdong 518129 (CN)
(74) Representative: Isarpatent
(86) International application number: PCT/CN2022/088735
(87) International publication number: WO 2023/205936

(57) **Abstract**

Embodiments of the present disclosure provide a semiconductor device and a preparation method therefor. The semiconductor device includes a substrate, where a surface of the substrate has a first area, a second area, and a third area; a first dielectric layer, applied to the first area and the third area of the substrate; a gate electrode, where the gate electrode is coupled to the substrate and includes a gate cap area and a contact area that is in contact with the second area of the substrate, and the gate cap area is separated from the first area of the substrate by a first spacing via the first dielectric layer; and a second dielectric layer, applied outside the gate electrode and the first dielectric layer, where in the third area, the second dielectric layer is separated from the substrate by a second spacing, and the second spacing is less than the first spacing. The first spacing by which the gate cap area is separated from the substrate is set to be larger than the second spacing by which the second dielectric layer is separated from the substrate, so that a capacitance value of a parasitic capacitance can be reduced without changing another design structure. In this way, a gain characteristic of the semiconductor device at a high frequency can be improved.

## Description

### TECHNICAL FIELD

The present disclosure relates to the field of semiconductor device preparation, and in particular, to a semiconductor device having a high gain and a preparation method therefor.

### BACKGROUND

The semiconductor industry has experienced three generations of material changes. First-generation semiconductor materials include silicon (Si) and germanium (Ge). Second-generation semiconductor materials include compound semiconductor materials, such as gallium arsenide (GaAs) and indium antimonide (InSb). In recent years, third-generation compound semiconductor materials represented by gallium nitride (GaN) and silicon carbide (SiC) have attracted wide attention due to excellent material characteristics thereof. Gallium nitride-based devices are widely used in the field of radio frequency devices due to advantages of the gallium nitride-based devices such as high mobility, strong breakdown resistance, and good heat dissipation characteristics.

A common radio frequency gallium nitride device uses a source-connected field plate technology to modulate electric field and capacitance distribution between a gate and a drain to achieve a specific high-frequency gain indicator. However, based on a conventional structure of a current gallium nitride semiconductor device in the industry, there is a problem of insufficient gain increasing space.

### SUMMARY

The present disclosure relates to technical solutions of a semiconductor device, and specifically provides a semiconductor device and a preparation method therefor.

According to a first aspect of the present disclosure, a semiconductor device is provided. The semiconductor device includes a substrate, where a surface of the substrate has a first area, a second area, and a third area; a first dielectric layer, applied to the first area and the third area of the substrate; a gate electrode, where the gate electrode is coupled to the substrate and includes a gate cap area and a contact area that is in contact with the second area of the substrate, and the gate cap area is separated from the first area of the substrate by a first spacing via the first dielectric layer; and a second dielectric layer, applied outside the gate electrode and the first dielectric layer, where in the third area, the second dielectric layer is separated from the substrate by a second spacing, and the second spacing is less than the first spacing.

The first spacing by which the gate cap area is separated from the substrate is set to be larger than the second spacing by which the second dielectric layer is separated from the substrate, so that a capacitance value of a parasitic capacitance can be reduced without changing another design structure. In this way, a gain characteristic of the semiconductor device at a high frequency can be improved.

In some implementations, a difference between the first spacing and the second spacing is between 20 nm and 500 nm. According to different requirements, the foregoing range implements flexibility of preparing the semiconductor device.

In an implementation, a heating component further includes: the first dielectric layer includes: a blanket dielectric layer, disposed in the first area and the third area; and a thickened dielectric layer, disposed between the blanket dielectric layer and the first area or between the blanket dielectric layer and the gate cap area, where a thickness of the thickened dielectric layer is between 20 nm and 500 nm. The blanket dielectric layer and the thickened dielectric layer may be made of a same material or different materials. This can improve flexibility of preparing the semiconductor device. In addition, costs and reliability may be considered in a process of preparing the semiconductor device.

In an implementation, the semiconductor device further includes a field plate, locally applied outside the second dielectric layer, where a spacing between the field plate and the gate electrode is substantially the same as a spacing between the field plate and the first dielectric layer. A source-connected field plate technology is used, and electric field and capacitance distribution between a gate and a drain is modulated, so that a required high-frequency gain indicator can be achieved.

In some implementations, the substrate includes one of the following materials: silicon carbide, gallium nitride, gallium nitride on silicon carbide, gallium nitride on sapphire, gallium nitride on silicon, aluminum indium nitride, and aluminum nitride. Various materials may be used to prepare the substrate. This makes the preparation of the semiconductor device more flexible.

In an implementation, the first dielectric layer or the second dielectric layer includes at least one of the following materials: silicon nitride, silicon oxynitride, silicon dioxide, aluminum nitride, aluminum oxide, and titanium dioxide. Similarly, a plurality of materials may be used to prepare the first dielectric layer or the second dielectric layer. This makes preparation of the semiconductor device more flexible.

According to a second aspect of the present disclosure, a preparation method for a semiconductor device is provided. The method includes: providing a substrate, where a surface of the substrate includes a first area corresponding to a gate cap area of a gate electrode of the semiconductor device, a second area corresponding to a contact area of the gate electrode, and a third area other than the first area and the second area; applying a first dielectric layer to the first area and the third area; applying the gate electrode, so that the contact area is in contact with the substrate, and the gate cap area is separated from the substrate by a first spacing; and applying a second dielectric layer outside the gate electrode and the first dielectric layer, where in the third area, the second dielectric layer is separated from the substrate by a second spacing, and the second spacing is less than the first spacing. According to the preparation method, a semiconductor device having a high gain characteristic at a high frequency can be prepared in a reliable manner.

In some implementations, the method further includes locally applying a field plate outside the second dielectric layer, where a spacing between the field plate and the gate electrode is substantially the same as a spacing between the field plate and the first dielectric layer. A semiconductor device prepared in this manner can have a needed high-frequency gain indicator.

In some implementations, the applying a first dielectric layer includes: applying a thickened dielectric layer to the first area and the second area; applying a blanket dielectric layer outside the third area and the thickened dielectric layer; and removing the blanket dielectric layer and the thickened dielectric layer outside the second area to expose the second area of the substrate.

In some implementations, the applying a thickened dielectric layer includes: applying the thickened dielectric layer to the entire substrate; and removing the thickened dielectric layer outside the third area to expose the third area of the substrate.

In some implementations, the applying a thickened dielectric layer includes: applying a photoresist to the third area of the substrate; applying the thickened dielectric layer outside the first area and the second area of the substrate and the photoresist; and removing the photoresist to expose the third area of the substrate.

In some implementations, the applying a first dielectric layer and the applying the gate electrode include: applying the blanket dielectric layer outside the entire substrate; applying the thickened dielectric layer outside the blanket dielectric layer; removing the blanket dielectric layer and the thickened dielectric layer outside the second area to expose the second area of the substrate; applying the gate electrode; and using the gate electrode as a self-aligned mask to remove the thickened dielectric layer outside the third area.

In some implementations, the applying a first dielectric layer and the applying the gate electrode include: applying the first dielectric layer outside the entire substrate, where the first dielectric layer has a first thickness, and the first thickness is equal to the first spacing; removing the first dielectric layer outside the second area to expose the second area of the substrate; applying the gate electrode; and using the gate electrode as a self-aligned mask to remove a part that is of the first dielectric layer outside the third area and that is in a thickness direction, so that the first dielectric layer at the third area has a second thickness less than the first thickness, where the second thickness is equal to the second spacing.

It should be understood that the content described in the summary is not intended to limit a key or important feature of the present disclosure, and is not intended to limit the scope of the present disclosure. The following descriptions facilitate understanding of other features of the present disclosure.

### BRIEF DESCRIPTION OF DRAWINGS

The foregoing and other objects, features, and advantages of embodiments of the present disclosure become easily understood by reading the following detailed descriptions with reference to the accompanying drawings. In the accompanying drawings, several embodiments of the present disclosure are shown by way of example and not limitation.
FIG. 1 is a diagram of a structure of a semiconductor device in a conventional solution in an example manner;
FIG. 2 is a diagram of a structure of a semiconductor device according to an embodiment of the present disclosure;
FIG. 3 is a flowchart of a preparation method for a semiconductor device according to an embodiment of the present disclosure; and
FIG. 4 to FIG. 9 are diagrams of stages in a process for preparing a semiconductor device according to different embodiments of the present disclosure.

Throughout all the accompanying drawings, same or similar reference numerals represent same or similar components.

### DESCRIPTION OF EMBODIMENTS

The following describes the principle and spirit of the present disclosure with reference to several example embodiments shown in the accompanying drawings. It should be understood that these specific embodiments are merely described to enable a person skilled in the art to better understand and implement the present disclosure, but are not intended to limit the scope of the present disclosure in any manner. In the following descriptions and claims, unless otherwise defined, all technical and scientific terms used in this specification have meanings as those commonly understood by a person of ordinary skill in the art to which the present disclosure belongs.

As used in this specification, the term "include" and similar terms should be understood as open inclusion, that is, "include but are not limited to". The term "based on" should be understood as "at least partially based on". The term "one embodiment" or "this embodiment" should be understood as "at least one embodiment". Terms such as "first", "second", and the like may indicate different objects or a same object, and are merely used to distinguish between indicated objects, but do not imply a specific spatial order, a time order, an importance order, or the like of the indicated objects.

The term "circuit" used in this specification indicates to one or more of the following: (a) an implementation of only a hardware circuit (such as an implementation of only an analog and/or digital circuit); (b) a combination of a hardware circuit and software, such as (if applicable): (i) a combination of an analog hardware circuit and/or a digital hardware circuit and software/firmware, and (ii) any part of a hardware processor and software (including a digital signal processor, software, and a memory that work together to enable an apparatus, such as a communication device or another electronic device, to perform various functions); and (c) a hardware circuit and/or a processor, such as a microprocessor or a part of a microprocessor, which requires software (such as firmware) for operation, but may not have software when software is not required for operation. The definition of a circuit is applicable to all usage scenarios of the term in this application (including the claims). In another example, the term "circuit" used herein also covers an implementation of only a hardware circuit or a processor (or a plurality of processors), or a part of a hardware circuit or a processor, or accompanying software or firmware. For example, if applicable to a particular claim element, the term "circuit" also covers a baseband integrated circuit or a processor integrated circuit, a network device, a terminal device, or a similar integrated circuit in another device.

Some semiconductor devices, such as a gallium nitride semiconductor device, are widely used in the field of radio frequency devices due to advantages of the semiconductor devices such as high mobility, strong breakdown resistance, and good heat dissipation. These semiconductor devices have a high indicator requirement on a gain characteristic at a high frequency. The gain feature at the high frequency mainly depends on whether a parasitic capacitance can be used to perform efficient and fast charging and discharging actions along with a signal under a high frequency working condition. Currently, in the industry, a passivation layer below a field plate metal is generally changed to modulate a channel capacitance under a bias voltage, to reduce a capacitance value of an output capacitance. However, only adjusting a parameter of the passivation layer may cause other negative effect, including electro-static discharge (Electro-static Discharge, ESD) breakdown, metal-insulator-metal (Metal-insulator-Metal, MIM) capacitor breakdown, breakdown characteristic degradation, and the like.

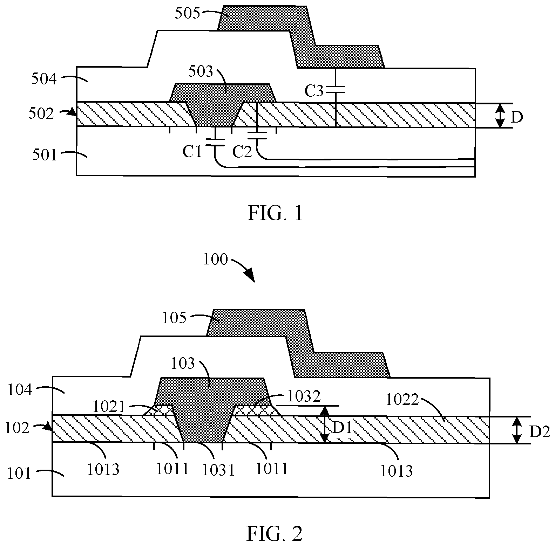

Specifically, some problems in a conventional solution are described by using an example in which a radio frequency gallium nitride device is used as a semiconductor device mentioned in this application. It should be understood that, in addition to the radio frequency gallium nitride device, the semiconductor device mentioned in this specification may also be any other appropriate semiconductor device. This is not described in detail in the following. FIG. 1 shows a common radio frequency gallium nitride semiconductor device. The semiconductor device uses a source-connected field plate technology. In a conventional solution, electric field and capacitance distribution between a gate and a drain is modulated to achieve a specific high-frequency gain indicator. As shown in FIG. 1, a conventional semiconductor device generally includes a substrate 501, a first dielectric layer 502, a gate electrode 503, a second dielectric layer 504, and a source-connected field plate 505. The gate electrode 503 and the field plate 505 are made of a metal material. In the semiconductor device, three capacitances C1, C2, and C3 generally need to be adjusted to optimize a gain indicator.

C1 represents a gate-drain intrinsic capacitance, and a determining factor thereof is a length of the gate electrode. C2 represents a gate cap-drain parasitic capacitance, and determining factors thereof include a gate cap length of the gate electrode 503, a thickness of the first dielectric layer 502 (that is, a distance between the gate cap and the substrate 501), and a dielectric constant of the first dielectric layer 502. C3 represents a capacitance below the field plate, and determining factors thereof include a length of the field plate, a location of the field plate, and thicknesses and dielectric constants of the first dielectric layer 502 and the second dielectric layer 504.

Generally, on a premise that a material of the substrate 501 is fixed, capacitance values of capacitances C1, C2, and C3 are generally affected by adjusting dielectric constants and thickness parameters of materials of the first dielectric layer 502 and the second dielectric layer 504, to further optimize the gain indicator. Specifically, for the semiconductor device shown in FIG. 1, to obtain a lower output capacitance, so as to increase a gain, capacitances of C1 and C2 generally need to be reduced, and a capacitance of C3 needs to be increased.

However, obviously, in a case in which a dielectric material is not changed, the thickness of the first dielectric layer 502 needs to be increased to reduce the capacitance of C2. However, an increase in the thickness of the first dielectric layer 502 causes an increase in a passivation thickness below the field plate 505, and consequently causes a decrease in a capacitance value of the capacitance C3. Therefore, simply increasing the thickness of the first dielectric layer 502 is inconsistent with an expected result, and gain control cannot be implemented.

Similarly, the capacitance value of the capacitance C2 may also be reduced by reducing the dielectric constant of the first dielectric layer 502, but the capacitance value of the capacitance C3 is also reduced. Therefore, simply adjusting physical characteristics such as the thickness and the dielectric constant of the first dielectric layer 502 to increase a gain of the device has a bottleneck.

If only the capacitance value of the capacitance C1 is adjusted, the adjustment needs to be implemented by adjusting a size of the gate electrode 503. However, the size of the gate electrode 503 is limited by an exposure limit of a lithography machine, and cannot be greatly adjusted. Therefore, the capacitance value adjustment of the capacitance C1 and even the increase of the gain of the device are extremely limited. In addition, the thickness of the second dielectric layer 504 is reduced to help increase the capacitance value of the capacitance C3, to increase the gain. However, reducing the thickness of the second dielectric layer 504 also reduces a distance between the gate electrode 503 and the field plate 505, to cause a problem of a poor withstand voltage characteristic between the gate electrode 503 and the field plate 505.

In addition, in a structure of the semiconductor device shown in FIG. 1, there is a transverse electric field stress distribution in a high-voltage reverse-biased stress state. High electric field peaks easily occur in locations corresponding to the gate cap of the gate electrode 503 and the field plate 505 in a transverse electric field. Under continuous high electric field stress, a time dependent dielectric breakdown (time dependent dielectric breakdown, TDDB) phenomenon is easily generated at a dielectric layer below the gate cap at the location corresponding to the electric field peak, and consequently, there is a high reliability risk.

To resolve or at least partially resolve the foregoing or other potential problems existing in a semiconductor device, embodiments of the present disclosure provide a semiconductor device 100 and a preparation method therefor. FIG. 2 is a diagram of a structure of the semiconductor device 100 according to an embodiment of the present disclosure. As shown in FIG. 2, the semiconductor device 100 according to this embodiment of the present disclosure generally includes a substrate 101, a first dielectric layer 102, a gate electrode 103, and a second dielectric layer 104. The gate electrode 103 includes a part that is in direct contact with the substrate 101 (which is referred to as a contact area 1031 hereinafter) and a part that is spaced from the substrate 101 via the first dielectric layer 102 (which is referred to as a gate cap area 1032 hereinafter). A plurality of different areas respectively corresponding to the first dielectric layer 102, and the contact area 1031 and the gate cap area 1032 of the gate electrode 103 exist on a surface of the substrate 101. For ease of description in the following, in the following description, these areas include a first area 1011 corresponding to the gate cap area 1032 of the gate electrode 103, a second area 1012 corresponding to the contact area 1031 of the gate electrode 103, and a third area 1013 other than the first area 1011 and the second area 1012. "Correspondence" herein represents areas covered by projections of areas (the contact area 1031 and the gate cap area 1032) corresponding to the gate electrode 103 in a vertical direction shown in FIG. 2.

It can be seen from FIG. 2 that the first dielectric layer 102 is applied to the first area 1011 and the third area 1013 of the substrate 101. The "applying" herein may indicate disposing the first dielectric layer 102 in a corresponding area by using any appropriate one or more process steps such as deposition. This is further described in the following. The gate electrode 103 is coupled to the substrate 101, where the contact area 1031 of the gate electrode 103 is in contact with the second area 1012 of the substrate 101, and the gate cap area 1032 is separated from the first area 1011 of the substrate 101 by a specific spacing (which is referred to as a first distance D1 hereinafter for ease of description) via the first dielectric layer 102. The second dielectric layer 104 is applied outside the gate electrode 103 and the first dielectric layer 102. The outside herein means that the second dielectric layer 104 covers the gate electrode 103 and the first dielectric layer 102. In the third area 1013, the second dielectric layer 104 is separated from the substrate 101 by a second spacing D2.

Different from a conventional semiconductor device, in the semiconductor device 100 according to this embodiment of this application, the second spacing D2 is less than the first spacing D1. This additionally increases the thickness that is between the gate cap and the substrate and that affects the parasitic capacitance C2 as mentioned above. In this way, the parasitic capacitance C2 is reduced. In addition, because an increase of a thickness of the first dielectric layer 102 is only retained in the gate cap area 1032 of the gate electrode, and is not extended to another area, the capacitance value of the capacitance C3 may still be maintained at a high level, so that a conflict that is mentioned above and that is caused by adjusting the capacitance values of the capacitances C1, C2, and C3 can be eliminated. In this manner, a gain of the semiconductor device 100 can be effectively increased.

In addition, only the thickness of the first dielectric layer 102 corresponding to the gate cap area 1032 (that is, the first area 1011) is increased, so that electric potential and electric field distribution on one side that is of the gate electrode 103 and that is close to a drain end can be readjusted. In this way, electric field stress at an original location where TDDB breakdown easily occurs is effectively weakened, to improve overall reliability of the semiconductor device 100.

In some embodiments, as shown in FIG. 2, the semiconductor device 100 further includes a field plate 105. The field plate 105 is locally applied outside the second dielectric layer 104 to form a structure of a source-connected field plate 105. Because the second dielectric layer 104 has a substantially consistent thickness, a spacing that is between the field plate 105 and the gate electrode 103 and that is in the vertical direction and a spacing that is between the field plate 105 and the first dielectric layer 102 and that is in the vertical direction are substantially the same. In this manner, with reference to the foregoing increase in the thickness of the first dielectric layer 102 corresponding to the gate cap area 1032, a parasitic capacitance of a gate electrode area is reduced. In addition, a capacitance value of a capacitance from a metal of the field plate 105 to a channel is increased, to further effectively increase the gain of the semiconductor device 100.

In some embodiments, a difference between the first spacing D1 and the second spacing D2 may be within a range of 20 nm to 500 nm, and includes endpoint values of 20 nm and 500 nm. In other words, a thickness of the first dielectric layer 102 corresponding to the first area 1011 of the substrate 101 or the gate cap area 1032 increases by a value between 20 nm and 500 nm. The specific thickness herein may be appropriately selected from the range based on various aspects such as stability and costs of the semiconductor device 100 that is needed, to improve flexibility and cost-effectiveness of preparing the semiconductor device 100.

The difference between the first spacing D1 and the second spacing D2 may be implemented by using a thickened dielectric layer 1021 of the first dielectric layer 102. The thickened dielectric layer 1021 is in the first dielectric layer 102 and is disposed in a part corresponding to the first area 1011. In addition to the thickened dielectric layer 1021, the first dielectric layer 102 further includes a blanket dielectric layer 1022. The blanket dielectric layer 1022 is disposed in the first area 1011 and the third area 1013 of the substrate 101. In some embodiments, the blanket dielectric layer 1022 and the thickened dielectric layer 1021 may be formed by using a same dielectric material in a same preparation step or different preparation steps. In some alternative embodiments, the blanket dielectric layer 1022 and the thickened dielectric layer 1021 may also be formed in different preparation processes by using different materials. This is further described below.

In some embodiments, the substrate 101 may be made of one of the following materials: silicon carbide, gallium nitride, gallium nitride on silicon carbide, gallium nitride on sapphire, gallium nitride on silicon, aluminum indium nitride, and aluminum nitride. Alternatively or additionally, in some embodiments, the first dielectric layer 102 or the second dielectric layer 104 may be made of at least one of the following materials: silicon nitride, silicon oxynitride, silicon dioxide, aluminum nitride, aluminum oxide, and titanium dioxide. In addition, in some embodiments, the gate electrode 103 and the field plate 105 may include at least one of the following metals or metal compounds: nickel, titanium, lead, platinum, gold, titanium nitride, tantalum nitride, and copper. It can be seen that the substrate 101, the first dielectric layer 102, the second dielectric layer 104, the gate electrode 103, and the field plate 105 may all be implemented by using a plurality of materials, to improve flexibility and cost effectiveness of preparing the semiconductor device 100. Certainly, it should be understood that the foregoing materials of the substrate 101, the first dielectric layer 102, the second dielectric layer 104, the gate electrode 103, and the field plate 105 are not exhaustive, and there may be other possible materials for preparing corresponding parts.

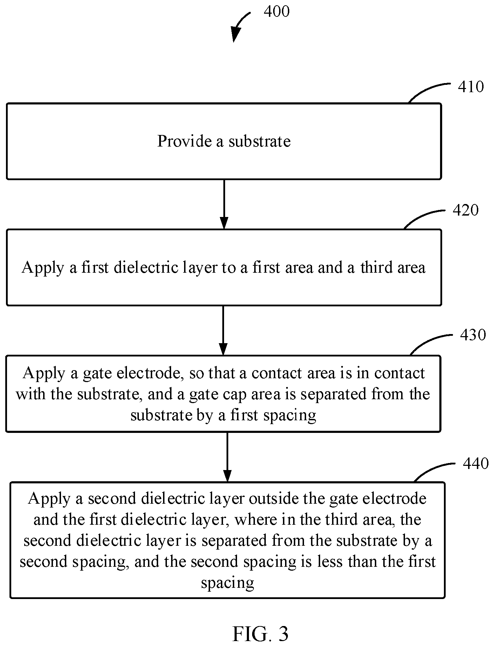

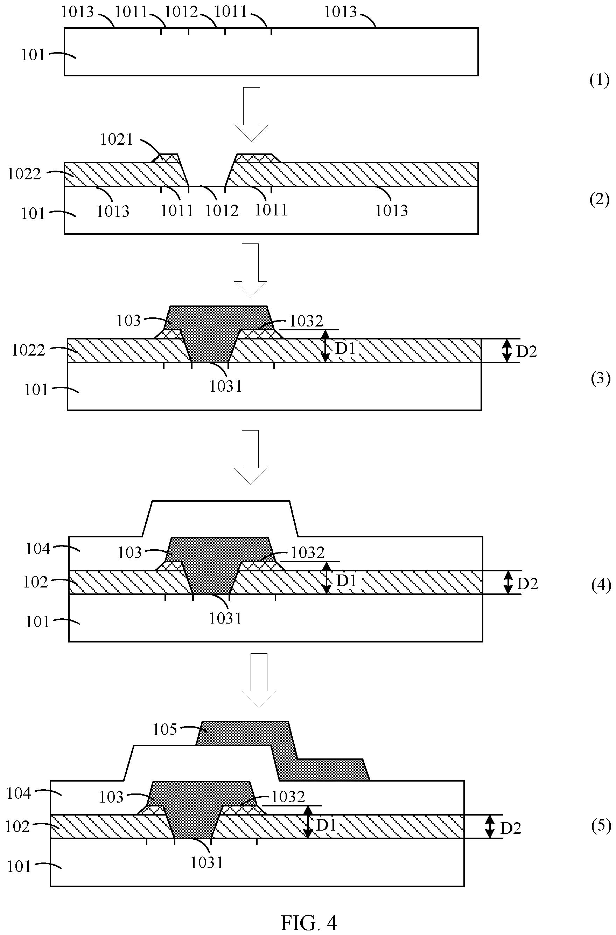

An embodiment of the present disclosure further provides a preparation method for a semiconductor device 100, to prepare the semiconductor device 100 mentioned above. FIG. 3 is a flowchart of a preparation method for the semiconductor device 100. FIG. 4 is a diagram of a structure that is of the semiconductor device 100 and that corresponds to each preparation step in FIG. 3. As shown in FIG. 3 and FIG. 4, in a block 410, a substrate 101 whose surface has a first area 1011, a second area 1012, and a third area 1013 is provided. The substrate 101 may be, for example, a wafer commonly mentioned in the art. Next, in a block 420, a first dielectric layer 102 is applied to the first area 1011 and the third area 1013 of the substrate 101. This may be implemented in any appropriate manner, and is further described below with reference to the accompanying drawings. After the first dielectric layer 102 is formed in the first area 1011 and the third area 1013, in a block 430, a gate electrode 103 is applied, so that a contact area 1031 of the gate electrode 103 is in contact with the substrate 101 in the second area 1012, and a gate cap area 1032 is separated from the substrate 101 by a first spacing D1. Then, in a block 440, a second dielectric layer 104 is applied outside the gate electrode 103 and the first dielectric layer 102, so that, in the second area 1012, the second dielectric layer 104 is separated from the substrate 101 by a second spacing D2, and the second spacing D2 is less than the first spacing D1. The semiconductor device 100 formed in this manner can have a reduced parasitic capacitance C2 and an increased capacitance C3 between a field plate 105 and the substrate 101, so that a gain and reliability of the semiconductor device 100 are improved.

In some embodiments, as shown in FIG. 4, the method may further include locally applying the field plate 105 outside the second dielectric layer 104 to form a source-connected field plate 105. This may be implemented by using any appropriate process and manner, such as a photolithographic method and etching. This is not limited in the present disclosure.

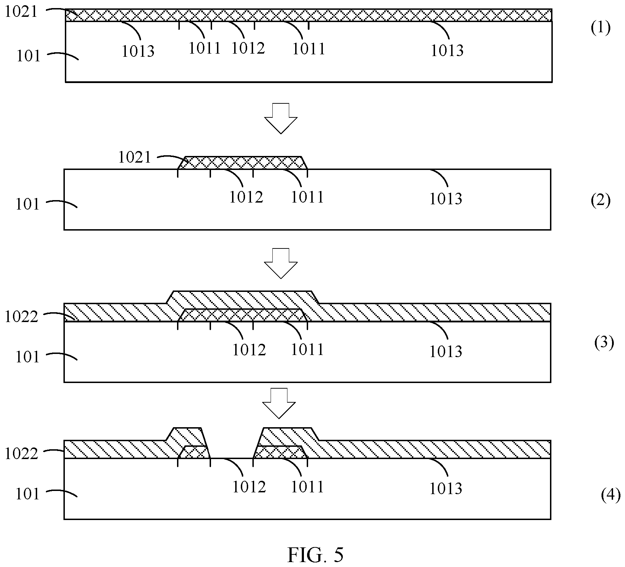

In addition, the step of forming the first dielectric layer 102 in the first area 1011 and the third area 1013 may be implemented in any appropriate manner. The following describes several example embodiments with reference to FIG. 5 to FIG. 9. It should be understood that these example embodiments are merely examples, and are not exhaustive or do not limit the protection scope of the present disclosure. The first dielectric layer 102 may alternatively be formed in any other appropriate manner, and details are not described in this specification.

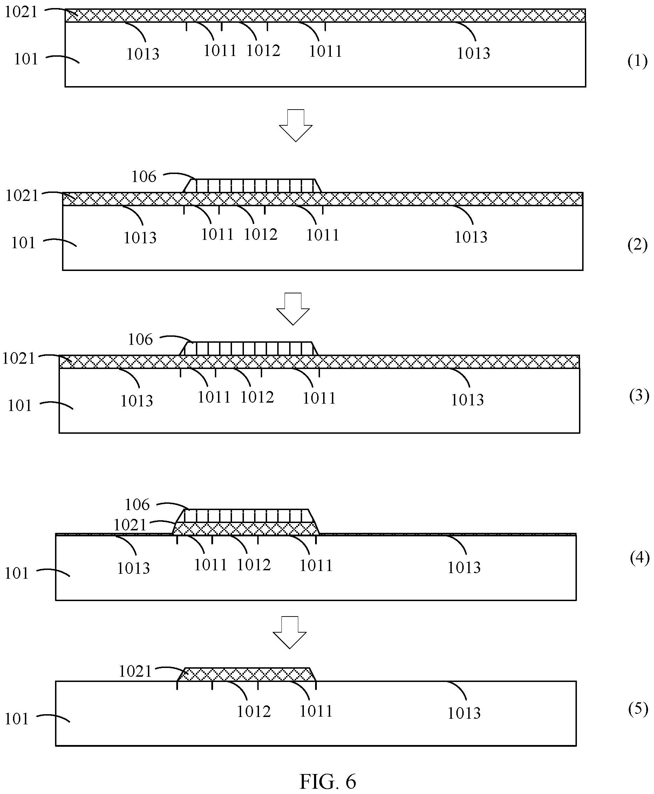

In some embodiments, a thickened dielectric layer 1021 in the first dielectric layer 102 may be first formed. The applying the first dielectric layer 102 may include applying the thickened dielectric layer 1021 to the first area 1011 and the second area 1012, as shown in (2) in FIG. 5. In some embodiments, the applying the thickened dielectric layer 1021 to the first area 1011 and the second area 1012 may be implemented by using the following steps. Step 1: Deposit a dielectric layer material whose thickness ranges from 20 nm to 500 nm (including endpoint values) on the entire substrate 101, as shown in (1) in FIG. 6. The substrate 101 mentioned above may include one of the following: silicon carbide, gallium nitride, gallium nitride on silicon carbide, gallium nitride on sapphire, gallium nitride on silicon, aluminum indium nitride, and aluminum nitride, where silicon carbide includes but is not limited to 4H-silicon carbide, 6H-silicon carbide, 3C-silicon carbide, and the like. A material used to prepare the thickened dielectric layer 1021 includes a single-layer or multi-layer laminated structure of a dielectric material such as silicon nitride, silicon oxynitride, silicon dioxide, aluminum nitride, aluminum oxide, or titanium dioxide. Step 2: Perform lithographic patterning, and define a photoresist pattern covering the first area 1011 and the second area 1012, as shown in (2) in FIG. 6.

Step 3: Etch, by using a dry/wet etching method, a dielectric layer below the pattern defined by a photoresist, as shown in (3) in FIG. 6. Etching is a process of removing a material from a surface of a material. Two main types of etching are wet etching and dry etching (for example, plasma etching) mentioned above. An etching process that relates to using liquid chemicals or etching agents to remove materials is referred to as wet etching. In a plasma etching process, also referred to as dry etching, plasma or etching gas is used to remove a substrate material. Dry etching produces gaseous products that need to be diffused into a large amount of gas and discharged by using a vacuum system. There are three types of dry etching (for example, plasma etching): chemical reaction (by using reactive plasma or gas), physical removal (generally through momentum transfer), and a combination of chemical reaction and physical removal. In addition, wet etching is merely a chemical process. Step 4: Further etch, by using a dry/wet etching solution, the pattern defined by the photoresist, to completely etch a dielectric layer in an area (that is, the third area 1013) that is not covered by the photoresist pattern until the substrate 101 is exposed, as shown in (4) in FIG. 6. Step 5: Remove the photoresist in a dry/wet manner, as shown in (5) in FIG. 6. In this manner, a state shown in (2) in FIG. 5 is formed. That is, in some embodiments, applying the thickened dielectric layer 1021 may include: applying the thickened dielectric layer 1021 to the entire substrate 101; and removing the thickened dielectric layer 1021 outside the third area 1013 (for example, by using the foregoing means) to expose the third area 1013 of the substrate 101, to form the state shown in (2) in FIG. 5.

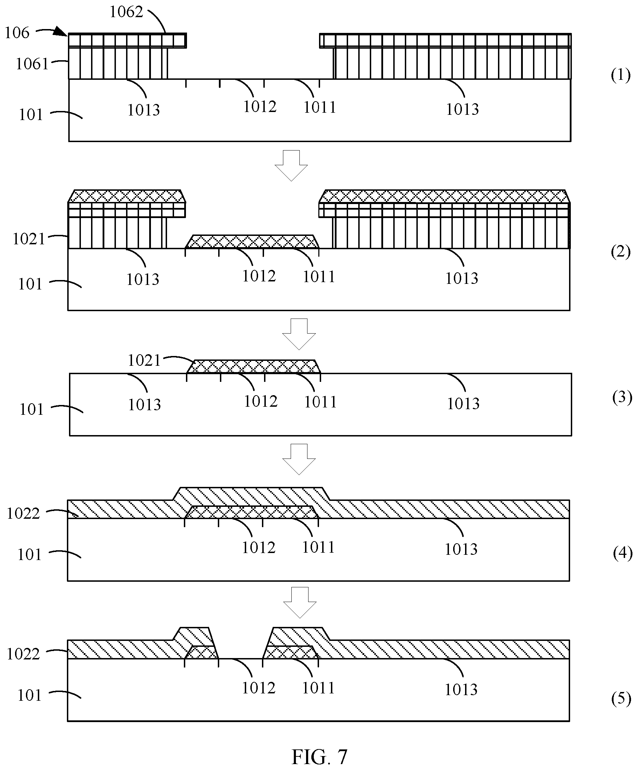

In some alternative embodiments, the applying the thickened dielectric layer 1021 may also be implemented in the following manner. Step 1: Perform pattern definition of a double-layer photoresist on the surface of the substrate 101, as shown in (1) in FIG. 7. This includes applying a first layer of photoresist 1061 and a second layer of photoresist 1062 to the third area 1013. Step 2: Deposit a first layer of dielectric layer material whose thickness ranges from 20 nm to 500 nm on the surface of the entire substrate 101. The dielectric layer material covers the first area 1011 and the second area 1012 of the substrate 101 and the third area 1013 covered with the double-layer photoresist, as shown in (2) in FIG. 7. Step 3: Perform dry/wet removal on the double-layer photoresist. Wet photoresist removal is divided into photoresist removal using an organic solvent and photoresist removal using an inorganic solvent. Photoresist removal using an organic solvent mainly means dissolving the photoresist in an organic solvent to remove the photoresist. Photoresist removal using an inorganic solvent means using a feature that the photoresist is also organic matter to oxidize a carbon element in the photoresist to carbon dioxide by using some inorganic solvents to remove the photoresist. Dry photoresist removal means removing the photoresist by using plasma. Then, to further remove the remaining dielectric material, the remaining dielectric layer material may be separately processed in a dry manner and a wet manner, to finally implement a case shown in (3) in FIG. 7 or (2) in FIG. 5. That is, in some embodiments, the applying the thickened dielectric layer 1021 may include applying the thickened dielectric layer 1021, including: applying the photoresist (including a first layer of photoresist 1061 and a second layer of photoresist 1062) to the third area 1013 of the substrate 101; applying the thickened dielectric layer 1021 outside the first area 1011 and the second area 1012 of the substrate 101 and the photoresist; and removing the photoresist to expose the third area 1013 of the substrate 101.

The foregoing describes a process of first forming the thickened dielectric layer 1021 of the first dielectric layer 102. After the thickened dielectric layer 1021 is formed in the first area 1011 and the second area 1012, as shown in (3) in FIG. 7 or (2) in FIG. 5, a second layer of dielectric layer material whose thickness ranges from 20 nm to 500 nm is deposited on a wafer surface, as shown in (3) in FIG. 5 and (4) in FIG. 7. The second layer of dielectric layer material finally forms a blanket dielectric layer 1022 of the first dielectric layer 102. The material may include a single-layer or multi-layer laminated structure of a dielectric material such as silicon nitride, silicon oxynitride, silicon dioxide, aluminum nitride, aluminum oxide, or titanium dioxide. As mentioned above, the blanket dielectric layer 1022 and the thickened dielectric layer 1021 of the first dielectric layer 102 may be made of a same material or different materials. Then, patterned etching is performed on the thickened dielectric layer 1021 and the blanket dielectric layer 1022 by using lithography and etching processes until the first area 1011 of the substrate 101 is completely exposed, as shown in (2) in FIG. 4, (4) in FIG. 5, and (5) in FIG. 7, so that the first dielectric layer 102 is formed in the first area 1011 and the third area 1013.

After the first dielectric layer 102 is formed in the first area 1011 and the third area 1013 of the substrate 101 according to the foregoing method, a process of applying the gate electrode 103 may be performed next. Specifically, in some embodiments, a first layer of metal laminated material whose thickness ranges from 20 nm to 1500 nm may be deposited outside the first area 1011 and the second area 1012 of the substrate 101, to form the gate electrode 103. Because the first area 1011 is covered by the blanket dielectric layer 1022 and the thickened dielectric layer 1021 of the first dielectric layer 102, a metal layer deposited in this area forms the gate cap area 1032, as shown in (3) in FIG. 4. Then, the second dielectric layer 104 is formed. Specifically, a third layer of dielectric layer material whose thickness ranges from 20 nm to 500 nm is deposited outside the gate electrode 103 and the first dielectric layer 102, to finally form the second dielectric layer 104, as shown in (4) in FIG. 4. Finally, in some embodiments, a metal laminated material whose thickness ranges from 20 nm to 500 nm is locally deposited outside the second dielectric layer 104, to form the field plate 105, as shown in (5) in FIG. 4.

The foregoing describes, with reference to FIG. 4 to FIG. 7, a different process of first forming the thickened dielectric layer 1021 of the first dielectric layer 102, then forming the blanket dielectric layer 1022 of the first dielectric layer 102, and finally forming the entire semiconductor device 100. It can be learned that, in some embodiments, in a finally formed semiconductor structure, the thickened dielectric layer 1021 of the first dielectric layer 102 may be disposed between the blanket dielectric layer 1022 and the substrate 101. Certainly, it should be understood that this is merely an example, and is not intended to limit the protection scope of the present disclosure. The first dielectric layer 102 may alternatively be implemented in any other appropriate manner. For example, in some alternative preparation processes, the blanket dielectric layer 1022 may be formed first, and then the thickened dielectric layer 1021 is formed.

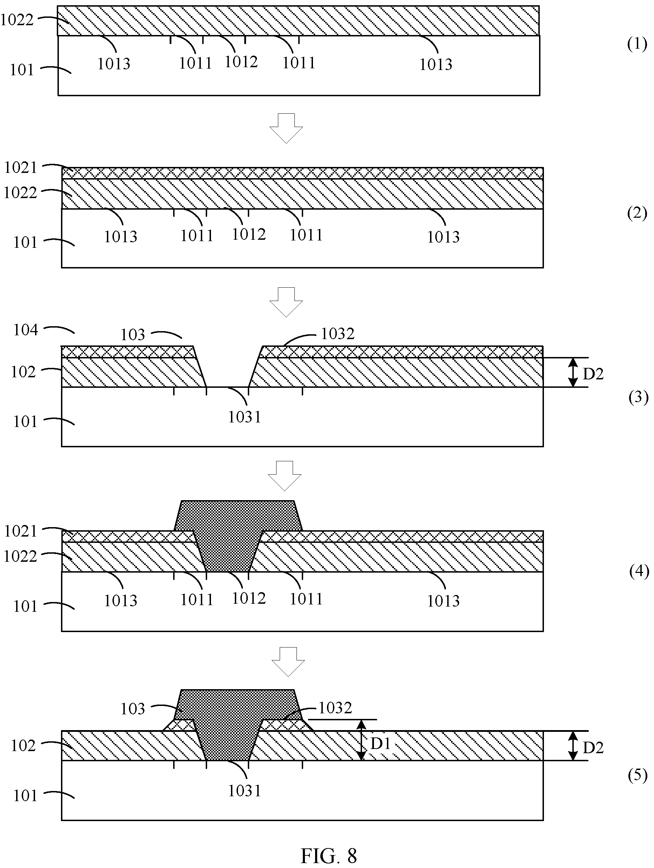

Specifically, as shown in FIG. 8, in some embodiments, a layer of dielectric layer material whose thickness ranges from 20 nm to 500 nm is deposited on the entire substrate 101. The dielectric layer material finally forms the blanket dielectric layer 1022 of the first dielectric layer 102, as shown in (1) in FIG. 8. A material used by the substrate 101 and a material used by the blanket dielectric layer 1022 of the first dielectric layer 102 are both similar to the materials used in the embodiments mentioned above, and details are not separately described herein again. In addition, the blanket dielectric layer 1022 is also a single-layer or laminated structure formed by one of silicon nitride, silicon oxynitride, silicon dioxide, aluminum nitride, aluminum oxide, or titanium dioxide. Step 2: Deposit a second layer of dielectric layer material whose thickness ranges from 20 nm to 500 nm on the entire substrate 101, as shown in (2) in FIG. 8. The second layer of dielectric layer material finally forms the thickened dielectric layer 1021. To facilitate a subsequent etching process, the second layer of dielectric layer differs from the first layer of dielectric layer in refractive indexes, deposition temperatures, density, and degrees of etching resistance. Step: Perform patterned etching on the two applied dielectric layers by using lithography and etching processes until the second area 1012 of the substrate 101 is completely exposed, as shown in (3) in FIG. 8.

Then, the gate electrode 103 is formed. Specifically, as shown in (4) in FIG. 8, a first layer of metal laminated material whose thickness ranges from 20 nm to 1500 nm is deposited outside the areas corresponding to the first area 1011 and the second area 1012 of the substrate 101. The metal laminated material finally forms the gate electrode 103. Then, a first layer of patterned metal is used as a hard self-aligned mask, and etching with a depth of 20 nm to 500 nm is performed on the second layer of dielectric layer in a dry/wet manner, so that an etched surface stays at an interface location between the second layer of dielectric layer and the first layer of dielectric layer, to retain the second layer of dielectric layer (that is, the thickened dielectric layer 1021) below the gate cap area 1032 of the gate electrode 103, as shown in (5) in FIG. 8. The following process is similar to the foregoing described process of applying the second dielectric layer 104 and the field plate 105. That is, a third layer of dielectric layer material whose thickness ranges from 20 nm to 500 nm is deposited outside the gate electrode 103 and the first dielectric layer 102, to finally form the second dielectric layer 104, as shown in (4) in FIG. 4. Finally, in some embodiments, a metal laminated material whose thickness ranges from 20 nm to 500 nm is locally deposited outside the second dielectric layer 104, to form the field plate 105, as shown in (5) in FIG. 4.

The thickened dielectric layer 1021 that is of the first dielectric layer 102 in the semiconductor device 100 and that is formed in this manner is located between the gate cap area 1032 of the gate electrode 103 and the first dielectric layer 102, and for ease of etching, the thickened dielectric layer 1021 and the blanket dielectric layer 1022 are made of different materials. In some embodiments, the thickened dielectric layer 1021 and the blanket dielectric layer 1022 in the first dielectric layer 102 may also be made of a same material in a same step.

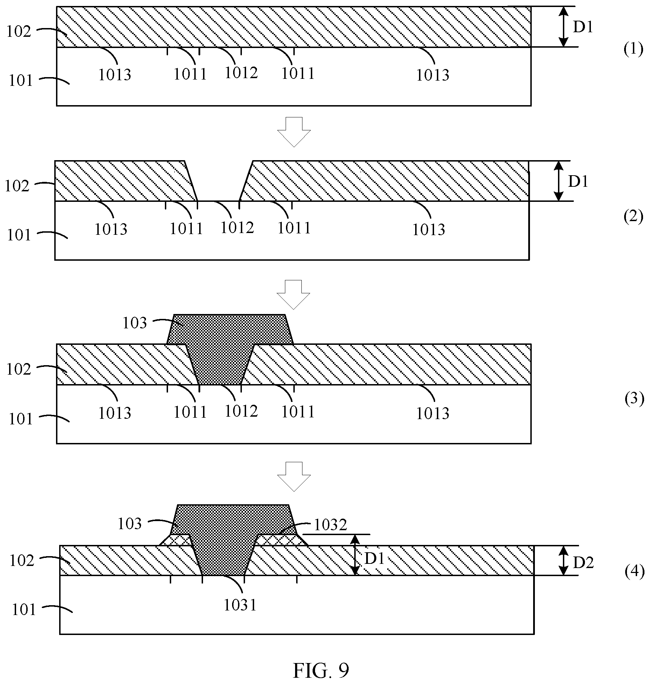

As shown in FIG. 9, in some embodiments, a dielectric layer material whose thickness ranges from 20 nm to 500 nm is deposited on the entire substrate 101, as shown in (1) in FIG. 9. The dielectric layer has a first thickness, and the first thickness is substantially equal to the first spacing D1 mentioned above. Then, patterned etching is performed on a dielectric layer area by using lithography and etching processes until the second area 1012 of the substrate 101 is completely exposed, as shown in (2) in FIG. 9. The first layer of metal laminated material whose thickness ranges from 20 nm to 1500 nm is deposited on an outer side of the first area 1011 and the second area 1012 of the substrate 101, to form the gate electrode 103. The first layer of patterned metal is used as the hard self-aligned mask, and etching with the depth of 20 nm to 500 nm is performed on the first layer of dielectric layer in the dry/wet manner. An etched dielectric layer corresponding to the third area 1013 has a second thickness, and the second thickness is equal to the second spacing D2 mentioned above. The following process is similar to the foregoing described process of applying the second dielectric layer 104 and the field plate 105. That is, the third layer of dielectric layer material whose thickness ranges from 20 nm to 500 nm is deposited outside the gate electrode 103 and the first dielectric layer 102, to finally form the second dielectric layer 104, as shown in (4) in FIG. 4. Finally, in some embodiments, a metal laminated material whose thickness ranges from 20 nm to 500 nm is locally deposited outside the second dielectric layer 104, to form the field plate 105, as shown in (5) in FIG. 4.

In the semiconductor device 100 prepared by using the foregoing different preparation processes, the thickness mentioned above that is between a gate cap and the substrate and that affects a parasitic capacitance C2 is additionally increased. In this way, the parasitic capacitance C2 is reduced. In addition, because an increase of a thickness of the first dielectric layer 102 is only retained in the gate cap area 1032 of the gate electrode, and is not extended to another area, the capacitance value of the capacitance C3 may still be maintained at a high level, so that a conflict that is mentioned above and that is caused by adjusting the capacitance values of the capacitances C1, C2, and C3 can be eliminated. In this manner, a gain of the semiconductor device 100 can be effectively increased.

In addition, only the thickness of the first dielectric layer 102 corresponding to the gate cap area 1032 (that is, the first area 1011) is increased, so that electric potential and electric field distribution on one side that is of the gate electrode 103 and that is close to a drain end can be readjusted. In this way, electric field stress at an original location where TDDB breakdown easily occurs is effectively weakened, to improve overall reliability of the device.

Although this application has been described in language specific to structural features and/or methodological actions, it should be understood that the subject matter defined in the appended claims is not limited to the specific features or actions described above. Rather, the specific features and actions described above are disclosed as example forms of implementing the claims.

## Claims

1. A semiconductor device, comprising:
a substrate (101), wherein a surface of the substrate (101) has a first area (1011), a second area (1012), and a third area (1013);
a first dielectric layer (102), applied to the first area (1011) and the third area (1013) of the substrate (101);
a gate electrode (103), coupled to the substrate (101), wherein the gate cap area (1032) comprises a gate cap area (1032) and a contact area (1031) that is in contact with the second area (1012) of the substrate (101), and the gate cap area (1032) is separated from the first area (1011) of the substrate (101) by a first spacing (D1) via the first dielectric layer (102); and
a second dielectric layer (104), applied outside the gate electrode (103) and the first dielectric layer (102), wherein in the third area (1013), the second dielectric layer (104) is separated from the substrate (101) by a second spacing (D2), and the second spacing (D2) is less than the first spacing (D1).

2. The semiconductor device according to claim 1, wherein a difference between the first spacing (D1) and the second spacing (D2) is between 20 nm and 500 nm.

3. The semiconductor device according to claim 1 or 2, wherein the first dielectric layer (102) comprises:
a blanket dielectric layer (1022), disposed in the first area (1011) and the third area (1013); and
a thickened dielectric layer (1021), disposed between the blanket dielectric layer (1022) and the first area (1011) or between the blanket dielectric layer (1022) and the gate cap area (1032), wherein a thickness of the thickened dielectric layer (1021) is between 20 nm and 500 nm.

4. The semiconductor device according to any one of claims 1 to 3, further comprising:
a field plate (105), locally applied outside the second dielectric layer (104), wherein a spacing between the field plate (105) and the gate electrode (103) is substantially the same as a spacing between the field plate (105) and the first dielectric layer (102).

5. The semiconductor device according to any one of claims 1 to 4, wherein the substrate (101) comprises one of the following materials: silicon carbide, gallium nitride, gallium nitride on silicon carbide, gallium nitride on sapphire, gallium nitride on silicon, aluminum indium nitride, and aluminum nitride.

6. The semiconductor device according to any one of claims 1 to 5, wherein the first dielectric layer (102) or the second dielectric layer (104) comprises at least one of the following materials: silicon nitride, silicon oxynitride, silicon dioxide, aluminum nitride, aluminum oxide, and titanium dioxide.

7. The semiconductor device according to any one of claims 4 to 6, wherein the gate electrode and the field plate comprise at least one of the following materials: nickel, titanium, lead, platinum, gold, titanium nitride, tantalum nitride, and copper.

8. A preparation method for a semiconductor device comprises:
providing a substrate (101), wherein a surface of the substrate (101) comprises a first area (1011) corresponding to a gate cap area (1032) of a gate electrode (103) of the semiconductor device, a second area (1012) corresponding to a contact area (1031) of the gate electrode (103), and a third area (1013) other than the first area (1011) and the second area (1012);
applying a first dielectric layer (102) to the first area (1011) and the third area (1013);
applying the gate electrode (103), so that the contact area (1031) is in contact with the substrate (101), and the gate cap area (1032) is separated from the substrate (101) by a first spacing (D1); and
applying a second dielectric layer (104) outside the gate electrode (103) and the first dielectric layer (102), wherein in the third area, the second dielectric layer (104) is separated from the substrate (101) by a second spacing (D2), and the second spacing (D2) is less than the first spacing (D1).

9. The method according to claim 8, further comprising:
locally applying a field plate (105) outside the second dielectric layer (104), wherein a spacing between the field plate (105) and the gate electrode (103) is substantially the same as a spacing between the field plate (105) and the first dielectric layer (102).

10. The method according to claim 8 or 9, wherein the applying a first dielectric layer (102) comprises:
applying a thickened dielectric layer (1021) to the first area (1011) and the second area (1012);
applying a blanket dielectric layer (1022) outside the third area (1013) and the thickened dielectric layer (1021); and
removing the blanket dielectric layer (1022) and the thickened dielectric layer (1021) outside the second area (1012) to expose the second area (1012) of the substrate (101).

11. The method according to claim 10, wherein the applying a thickened dielectric layer (1021) comprises:
applying the thickened dielectric layer (1021) to the entire substrate (101); and
removing the thickened dielectric layer (1021) outside the third area (1013) to expose the third area (1013) of the substrate (101).

12. The method according to claim 10, wherein the applying a thickened dielectric layer (1021) comprises:
applying a photoresist (106) to the third area (1013) of the substrate (101);
applying the thickened dielectric layer (1021) outside the first area (1011) and the second area (1012) of the substrate (101) and the photoresist (106); and
removing the photoresist (106) to expose the third area (1013) of the substrate (101).

13. The method according to claim 8 or 9, wherein the applying a first dielectric layer (102) and the applying the gate electrode (103) comprise:
applying the blanket dielectric layer (1022) outside the entire substrate (101);
applying the thickened dielectric layer (1021) outside the blanket dielectric layer (1022);
removing the blanket dielectric layer (1022) and the thickened dielectric layer (1021) outside the second area (1012) to expose the second area (1012) of the substrate (101);
applying the gate electrode (103); and
using the gate electrode (103) as a self-aligned mask to remove the thickened dielectric layer (1021) outside the third area (1013).

14. The method according to claim 8 or 9, wherein the applying a first dielectric layer (102) and the applying the gate electrode (103) comprise:
applying the first dielectric layer (102) outside the entire substrate (101), wherein the first dielectric layer (102) has a first thickness, and the first thickness is equal to the first spacing (D 1);
removing the first dielectric layer (102) outside the second area (1012) to expose the second area (1012) of the substrate (101);
applying the gate electrode (103); and
using the gate electrode (103) as a self-aligned mask to remove a part that is of the first dielectric layer (102) outside the third area (1013) and that is in a thickness direction, so that the first dielectric layer (102) at the third area (1013) has a second thickness less than the first thickness, wherein the second thickness is equal to the second spacing (D2).
